# EUROPÄISCHE PATENTSCHRIFT

(11) **EP 2 783 225 B1**
(45) Veröffentlichungstag und Bekanntmachung des Hinweises auf die Patenterteilung: **06.03.2019**
(21) Anmeldenummer: 13700549.2
(22) Anmeldetag: 11.01.2013
(51) Int. Cl.: G01R 15/20

(54) **ANORDNUNG UND VERFAHREN ZUR POTENTIALGETRENNTEN STROMMESSUNG AN EINEM ELEKTRISCHEN LEITER**
ARRANGEMENT AND METHOD FOR ISOLATED CURRENT MEASUREMENT ON AN ELECTRIC CONDUCTOR
SYSTÈME ET PROCÉDÉ POUR EFFECTUER UNE MESURE DE COURANT ISOLÉE GALVANIQUEMENT AU NIVEAU D'UN CONDUCTEUR ÉLECTRIQUE

(30) Priorität: 16.01.2012 DE 102012200556
(43) Veröffentlichungstag der Anmeldung: 01.10.2014
(73) Patentinhaber: Siemens Aktiengesellschaft, 80333 München (DE)
(72) Erfinder: GÖTZ, Jürgen, 91315 Höchstadt/Aisch (DE); HAIN, Stefan, 91090 Effeltrich (DE); OSTERMAIER, Jochen, 91056 Erlangen (DE)
(86) Internationale Anmeldenummer: PCT/EP2013/050441
(87) Internationale Veröffentlichungsnummer: WO 2013/107689

(56) Entgegenhaltungen:
- EP-A1- 0 264 612
- EP-A1- 0 856 737
- US-A1- 2005 134 253
- US-A1- 2005 156 587

## Beschreibung

Die Erfindung betrifft eine Anordnung sowie ein Verfahren zur potentialgetrennten Strommessung an einem elektrischen Leiter mit einem Messkörper mit einer durchgehenden Öffnung zur Durchführung des elektrischen Leiters.

Die Messung von Strömen in Leitern wird häufig benötigt. Bei Hochspannungsleitungen ist eine galvanische Trennung bei der Messung erforderlich, was die Strommessung bedeutend schwieriger macht. Eine berührungsfreie Vorgehensweise zur Messung von Wechselströmen ist die Verwendung der bekannten Rogowski-Spule.

EP0264612 offenbart einen Stromsensor, der mit einem Ringkörper arbeitet, durch den zumindest ein auszuwertender Leiter hindurchgeführt werden kann und von dem ein Messsignal abgenommen wird. Der Ringkörper besteht aus magnetostriktivem Material.

Es ist Aufgabe der vorliegenden Erfindung, eine verbesserte Anordnung sowie ein verbessertes Verfahren anzugeben, die eine Strommessung an stromführenden elektrischen Leitern bei galvanischer Trennung erlauben.

Diese Aufgabe wird durch eine Anordnung mit den Merkmalen von Anspruch 1 gelöst. Eine weitere Lösung besteht in einem Verfahren mit den Merkmalen von Anspruch 12. Die abhängigen Ansprüche betreffen vorteilhafte Ausgestaltungen der Erfindung. Die erfindungsgemäße Anordnung zur Strommessung an einem elektrischen Leiter umfasst einen Messkörper. Der Messkörper weist eine durchgehende Öffnung zur Durchführung des elektrischen Leiters auf. Ist der elektrische Leiter gegeben, umschließt der Messkörper den Leiter. Dabei muss das Umschließen nicht vollständig sein. So kann der Messkörper so einseitig offen gestaltet sein, dass er ohne bauliche Veränderungen eines bestehenden Leiters um diesen herum angelegt werden kann. Alternativ kann der Messkörper den Leiter auch vollständig umschließen. In einer Ausgestaltung der Erfindung ist der Messkörper als geschlossener oder fast geschlossener Ring ausgebildet, der den Leiter umschließen kann.

Dabei wird der Messkörper zweckmäßig den Leiter berührungsfrei umschließen. Alternativ kann der Messkörper den elektrischen Leiter auch berühren oder fest umfassen, wobei in diesem Fall eine geeignete Isolierung zweckmäßig ist.

Weiterhin weist der Messkörper ein Material mit Magnetostriktion auf. Das Material kann beispielsweise ein ferromagnetisches Material sein. Ein Material mit Magnetostriktion reagiert magnetostriktiv, d.h. unter dem Einfluss eines Magnetfelds ändert es - meistens unter Beibehaltung des Volumens - seine Länge. Zweckmäßig, aber nicht zwingend, besteht der Messkörper zu großen Teilen oder vollständig aus dem Material.

Weiterhin umfasst die Anordnung eine mit dem Messkörper verbundene Messeinrichtung. Die Messeinrichtung ist ausgestaltet, ein Signal zu erzeugen, das ein Maß für die magnetostriktive Größenänderung oder Längenänderung des Materials ist.

Es wird also vorteilhaft eine Messeinrichtung für elektrischen Strom durch einen Leiter angegeben, die in der Lage ist, berührungsfrei den Strom zu erfassen. Besonders vorteilhaft ist, dass im Gegensatz zu den bekannten Rogowski-Spulen neben den AC-Anteilen des Stroms auch ein DC-Anteil des Stroms ermittelt werden kann. Weiterhin ist im Gegensatz zur Messung mit Rogowski-Spulen auch keine zeitliche Integration der sich ergebenden Spannung in der Rogowski-Spule nötig, da die Größenänderung des magnetostriktiven Materials direkt - nicht über eine zeitliche Änderung - mit dem Magnetfeld verbunden ist.

Bei dem erfindungsgemäßen Verfahren zur Strommessung an einem stromführenden Leiter wird ein Messkörper mit einem Material mit Magnetostriktion in die Nähe des Leiters gebracht, mittels einer mit dem Messkörper verbundenen Messeinrichtung ein Signal erzeugt wird, das ein Maß für eine magnetostriktive Größenänderung des Materials ist und aus dem Signal der Strom im Leiter ermittelt.

In einer Ausgestaltung der Erfindung weist der Messkörper einen Hohlraum auf, der zweckmäßig mit einer Flüssigkeit gefüllt ist. Die Anordnung weist bevorzugt weiterhin einen mit der Flüssigkeit in Kontakt stehenden Drucksensor auf. In einer Alternativen Ausgestaltung werden die Druckänderungen durch eine Erfassung eines Höhenstandes der Flüssigkeit gemessen.

In einer alternativen Ausgestaltung weist der Messkörper ebenfalls einen Hohlraum sowie eine Einrichtung zur Erzeugung von Schall sowie ein Mikrofon zur Aufnahme des Schalls. Die letzteren Einrichtungen sind so ausgerichtet, dass der Hohlraum vom Schall durchlaufen wird und das Mikrofon den Schall nach dem Durchlaufen aufnimmt. Der Hohlraum ist dabei bevorzugt mit einem geeigneten Gas, Flüssigkeit oder festem Material gefüllt.

Hierbei ist es möglich, die Einrichtung zur Erzeugung von Schall und das Mikrofon als eine Einheit herzustellen. Dann ist es zweckmäßig, ein Ende des Hohlraums abzuschließen, sodass der Schall an diesem reflektiert wird. Alternativ können beide Enden des Hohlraums zur Einrichtung zur Erzeugung von Schall und/oder zum Mikrofon hin offen sein.

In einer weiteren alternativen Ausgestaltung weist der Messkörper einen Lichtwellenleiter auf, der der Messkörper durchläuft und kraftschlüssig mit ihm verbunden ist. Dann ist es möglich, die magnetostriktive Größenänderung oder Längenänderung des Materials beispielsweise mittels eines Laserinterferometers zu ermitteln.

Gemäß einer weiteren alternativen Ausgestaltung weist der Messkörper Spiegel oder verspiegelte Flächen auf, die der Reflektion und Führung von beispielsweise Laserlicht dienen. Das Licht wird dabei beispielsweise entlang einer dem elektrischen Leiter zugewandten Innenfläche geführt und mehrfach reflektiert, um einen Teil der Oberfläche des Messkörpers entlangzulaufen.

Vorteil der optischen Messmethoden ist die Unabhängigkeit und Unempfindlichkeit gegenüber den elektrischen Gegebenheiten in der Umgebung des Stromleiters und die Möglichkeit, sämtliche Komponenten wie Leucht- oder Laserdioden und Auswerteelektronik in einiger Entfernung von der Messstelle unterbringen zu können.

In einer bevorzugten Ausgestaltung der Erfindung ist der Messkörper magnetisch oder mechanisch vorgespannt. Damit wird erreicht, dass neben der Größe auch die Flussrichtung des Stroms erfassbar ist.

In einer weiteren Weiterbildung der Erfindung ist der Messkörper spulenartig ausgebildet ist mit einer Mehrzahl von Windungen um die Öffnung zur Durchführung des elektrischen Leiters. Hierdurch wird vorteilhaft eine Vervielfachung des Messsignals entsprechend der Anzahl der Windungen erreicht.

In einer weiteren Ausgestaltung der Erfindung weist die Anordnung einen Temperatursensor zur Bestimmung der Temperatur des Messkörpers auf. Damit ist es möglich, Verfälschungen der Messung der magnetostriktiven Größenänderung oder Längenänderung durch Temperaturänderungen zu kompensieren.

In einer alternativen Ausgestaltung der Erfindung weist die Anordnung einen zweiten Messkörper mit einer zweiten Messeinrichtung auf, wobei der zweite Messkörper eine geringe oder keine Magnetostriktion aufweist. Durch eine Messung der Größenänderung des zweiten Messkörpers ist der Temperatureinfluss bekannt und kann ebenfalls kompensiert werden. Dabei ist es zweckmäßig, wenn die Messkörper gleiche Temperaturausdehnungskoeffizienten aufweisen.

Bevorzugte, jedoch keinesfalls einschränkende Ausführungsbeispiele für die Erfindung werden nunmehr anhand der Zeichnung näher erläutert. Dabei sind die Merkmale schematisiert dargestellt und sich entsprechende Merkmale sind mit gleichen Bezugszeichen markiert. Die Figuren zeigen dabei im Einzelnen:
Figur 1 einen Stromsensor mit einem Drucksensor,
Figur 2 einen akustischen Stromsensor mit Schallerzeuger und Mikrofon,
Figur 3 einen optischen Stromsensor mit optischer Faser,
Figur 4 einen optischen Stromsensor mit Spiegeln und
Figur 5 einen optischen Stromsensor mit verspiegelten Flächen.

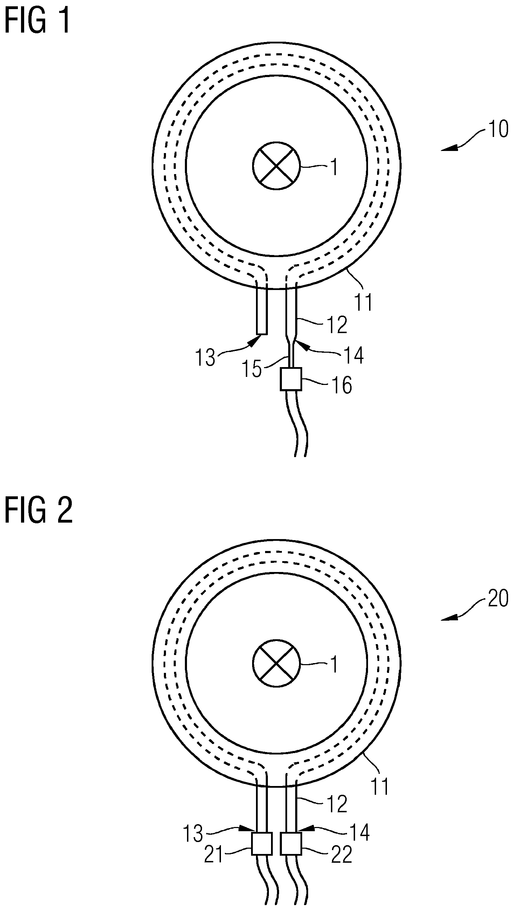

Figur 1 zeigt im Querschnitt ein erstes Ausführungsbeispiel für einen ersten Stromsensor 10, der berührungsfrei um einen stromführenden Leiter 1 herum angeordnet ist. Der erste Stromsensor 10 umfasst einen Messkörper 11, der als geschlossener Ring aus Eisen realisiert ist. Alternativ zu Eisen können auch andere Materialien wie beispielsweise Nickel oder TbFe₂ verwendet werden. Ein Rohr 12 verläuft im Messkörper 11 und umläuft damit ebenfalls den Leiter 1, ist aber nicht als Kreis geschlossen. An einer Stelle des Messkörpers 11 treten beide Enden 13, 14 des Rohrs 12 aus dem Messkörper 11 aus. Ein erstes Ende 13 ist dabei dicht abgeschlossen. Das andere Ende 14 weist außerhalb des Messkörpers 11 eine Verjüngung 15 auf, an deren Ende ein Drucksensor 16 angeordnet ist. Der Drucksensor 16 selbst ist wiederum elektrisch mit einer Auswerteeinrichtung verbunden, die nicht dargestellt ist. Das Rohr 12 ist im vorliegenden Beispiel mit einem Öl gefüllt.

Ein Strom im Leiter 1 erzeugt im den Leiter 1 herum ein Magnetfeld in bekannter Weise. Das Magnetfeld bewirkt eine magnetostriktive Größenänderung des Messkörpers 11. Diese Größenänderung bewirkt eine analoge Volumenänderung des eingebetteten Rohrs 12. Diese führt zu einer am Drucksensor 16 aufnehmbaren Druckänderung im Rohr 12. Die Verjüngung 15 an einem Ende 14 des Rohrs 12 bewirkt hierbei eine Verstärkung des Messsignals.

In alternativen Ausgestaltungen werden andere Messmethoden als das Erfassen des Drucks durch den Drucksensor 16 verwendet. Beispielsweise kann die Volumenänderung des Rohrs 12 und die damit verbundene räumliche Verschiebung des enthaltenen Öls über eine Messung eines Flüssigkeitsstandes erfasst werden. Dies wiederum kann beispielsweise optisch oder kapazitiv erfolgen.

Figur 2 zeigt als zweites Ausführungsbeispiel für die Erfindung einen zweiten Stromsensor 20. Neben den bereits vom ersten Stromsensor 10 bekannten Elementen Leiter 1 und Messkörper 11 sowie Rohr 12 sind beim zweiten Stromsensor 20 ein Mikrofon 21 und ein Schallerzeuger 22 an den Enden 13, 14 des Rohrs 12 angeordnet. Das Rohr 12 ist in diesem Ausführungsbeispiel mit einem geeigneten Gas oder einer Flüssigkeit oder einem Feststoff angefüllt. Vom Schallerzeuger 22 erzeugte akustische Signale bewegen sich im Rohr 12 entlang und erreichen nach Durchlaufen des Rohrs 12 das Mikrofon 21. Eine Größenänderung des Messkörpers 11 wird in diesem Fall aus den Eigenschaften des akustischen Signals gewonnen, beispielsweise durch eine Laufzeitmessung.

Es ist auch möglich, den zweiten Stromsensor 20 dahingehend zu verändern, dass eines der Enden 13 des Rohrs 12 wie beim ersten Stromsensor 10 geschlossen ist und das akustische Signal reflektiert. Schallerzeuger 22 und Mikrofon 21 sind dann am anderen Ende 14 nahe beieinander oder als eine bauliche Einheit oder als gemeinsames Bauteil realisiert.

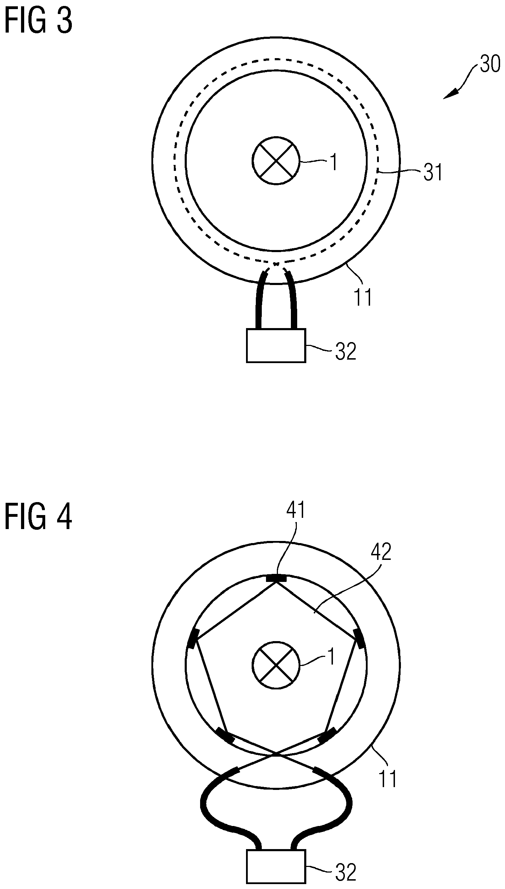

Figur 3 zeigt als drittes Ausführungsbeispiel für die Erfindung einen dritten Stromsensor 30. Der dritte Stromsensor 30 umfasst die bereits vom ersten Stromsensor 10 bekannten Elemente Leiter 1 und Messkörper 11. An der Stelle eines Rohrs 12 ist beim dritten Stromsensor 30 eine optische Faser 31 fest mit dem Messkörper 11 verklebt. Die Enden der optischen Faser 31 sind mit einem Laserinterferometer 32 gekoppelt. Größenänderungen des Messkörpers 11 führen zu einer Streckung oder Stauchung der optischen Faser 31. Damit verkürt oder verlängert sich der optische Weg eines Laserstrahls, der in die Faser eingekoppelt wird. Mittels des Laserinterferometers 32 wird die Größenänderung des Messkörpers 11 bestimmt. Auch beim dritten Stromsensor 30 ist es möglich, den Laserstrahl an einem der Enden der optischen Faser 31 zu reflektieren und am anderen Ende ein- und auszukoppeln.

Figur 4 zeigt als viertes Ausführungsbeispiel für die Erfindung einen vierten Stromsensor 40. Der vierte Stromsensor 40 verwendet wie der dritte Stromsensor 30 eine optische Messmethode. Hierbei wird der Laserstrahl 42 jedoch im Bereich des Messkörpers 11 nicht in einer optischen Faser 31 geführt, sondern umläuft den Leiter 1 frei und von Spiegeln 41 geeignet reflektiert. Eine Weglängenänderung wird wie beim dritten Stromsensor 30 mit dem Laserinterferometer 32 ermittelt. Beim vierten Ausführungsbeispiel kann weiterhin anhand des Austrittswinkels des Laserstrahls 42 aus der Anordnung der Spiegel 41 darauf geschlossen werden, ob der Leiter 1 im Zentrum des Messkörpers 11 angeordnet ist. Ist das nicht der Fall, wird der Austrittswinkel aufgrund der über den Messkörper 11 hinweg ungleichmäßigen Längenänderung verändert. Der Austrittswinkel lässt sich beispielsweise über ein lichtempfindliches Array ermitteln, das den Auftreffpunkt des Laserstrahls 42 in einer festgelegten Entfernung vom letzten Spiegel 41 bestimmt.

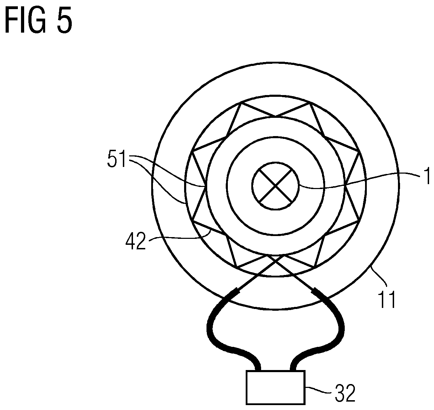

Figur 5 zeigt als fünftes Ausführungsbeispiel für die Erfindung einen fünften Stromsensor 50. Der fünfte Stromsensor 50 ähnelt dem vierten Stromsensor 40. Der fünfte Stromsensor 50 weist jedoch keine Spiegel 41 auf. Stattdessen ist beim fünften Stromsensor 50 der Messkörper in der Form von zwei konzentrischen Ringen ausgeführt. Die zum Zwischenraum zwischen den Ringen gerichteten Innenflächen 51 der Ringe sind verspiegelt und der Laserstrahl 42 läuft in diesem Zwischenraum.

Einige Ausführungsdetails wurden in der vorangegangenen Beschreibung der Ausführungsbeispiele noch nicht genannt. Diese Ausführungsdetails sind nicht notwendig, aber vorteilhaft.

Magnetfelder entgegengesetzter Richtung, aber gleicher Größe, führen zu gleichen Größenänderungen magnetostriktiver Materialien. Daher ist es vorteilhaft, wenn auch nicht notwendig, wenn das Material des Messkörpers 11 magnetisch oder mechanisch vorgespannt ist. Dadurch ist eine Bestimmung der Stromrichtung möglich.

Weiterhin ist es vorteilhaft, wenn der Messkörper 11 mitsamt den damit verbundenen Elementen wie beispielsweise der optischen Faser 41 mehrfach um den Leiter 1 geführt sind. Hierdurch wird das Signal proportional zur Anzahl der Umläufe erhöht.

Schließlich beeinflussen Temperaturänderungen ebenfalls die Größe des Messkörpers 11. Dadurch wird das Signal verfälscht. Zur Kompensation des Temperatureinflusses ist es beispielsweise möglich, die Temperatur des Messkörpers 11 - beispielsweise mittels eines Infrarotsensors - an einer oder mehreren Stellen zu ermitteln und den Temperatureinfluss rechnerisch zu entfernen. Alternativ ist es möglich, einen zweiten Messkörper und weitere entsprechende Messelemente bereitzustellen und zu verwenden, wobei der zweite Messkörper nicht magnetostriktiv reagiert. Idealerweise weist der zweite Messkörper dabei im Wesentlichen den gleichen Temperaturausdehnungskoeffizienten auf. Das zusätzliche Messsystem mit dem zweiten Messkörper ermittelt dann lediglich die temperaturabhängige Signaländerung, die damit aus dem Messergebnis des eigentlichen Stromsensors herausgerechnet werden kann.

Die beschriebenen Stromsensoren erlauben vorteilhaft eine potentialgetrennte Messung von Wechsel- und auch Gleichströmen. Sie können robust und für den Einsatz in rauen Umgebungsbedingungen aufgebaut werden. Im Bereich des Messkörpers befinden sich keine stromführenden elektrischen Teile.

## Patentansprüche

1. Anordnung (10, 20, 30, 40, 50) zur Strommessung an einem elektrischen Leiter (1) mit
- einem Messkörper (11), der eine durchgehende Öffnung zur Durchführung des elektrischen Leiters (1) sowie ein Material mit Magnetostriktion aufweist und spulenartig ausgebildet ist mit einer Mehrzahl von Windungen um die Öffnung zur Durchführung des elektrischen Leiters (1),
- einer mit dem Messkörper (11) verbundenen Messeinrichtung, die ausgestaltet ist, ein Signal zu erzeugen, das ein Maß für eine magnetostriktive Größenänderung des Materials ist.

2. Anordnung (10, 20, 30, 40, 50) gemäß Anspruch 1, bei der der Messkörper (11) einen Hohlraum (12) aufweist.

3. Anordnung (10, 20, 30, 40, 50) gemäß Anspruch 2, bei der der Hohlraum (12) mit einer Flüssigkeit angefüllt ist.

4. Anordnung (10, 20, 30, 40, 50) gemäß Anspruch 2 oder 3, bei der die Messeinrichtung einen Drucksensor (16) zur Messung des Drucks im Hohlraum (12) umfasst.

5. Anordnung (10, 20, 30, 40, 50) gemäß Anspruch 2 oder 3, bei der die Messeinrichtung eine Einrichtung (22) zur Erzeugung von Schall sowie ein Mikrofon (21) zur Aufnahme des Schalls umfasst.

6. Anordnung (10, 20, 30, 40, 50) gemäß Anspruch 1, bei der die Messeinrichtung einen Lichtwellenleiter (31) umfasst, der kraftschlüssig mit dem Messkörper (11) verbunden ist.

7. Anordnung (10, 20, 30, 40, 50) gemäß einem der Ansprüche 1 oder 2, die Spiegel (41) oder verspiegelte Oberflächen (51) umfasst.

8. Anordnung (10, 20, 30, 40, 50) gemäß einem der vorangehenden Ansprüche, bei der der Messkörper (11) magnetisch oder mechanisch vorgespannt ist.

9. Anordnung (10, 20, 30, 40, 50) gemäß einem der vorangehenden Ansprüche mit einem Temperatursensor zur Bestimmung der Temperatur des Messkörpers (11).

10. Anordnung (10, 20, 30, 40, 50) gemäß einem der vorangehenden Ansprüche, die einen zweiten Messkörper mit einer zweiten Messeinrichtung umfasst, wobei der zweite Messkörper eine geringe oder keine Magnetostriktion aufweist

11. Anordnung (10, 20, 30, 40, 50) gemäß Anspruch 10, bei dem die Messkörper (11) gleiche Temperaturausdehnungskoeffizienten aufweisen.

12. Verfahren zur Strommessung an einem stromführenden Leiter (1), bei dem
- ein spulenartig ausgebildeter Messkörper (11) mit einer Mehrzahl von Windungen um eine Öffnung zur Durchführung des Leiters (1) und mit einem Material mit Magnetostriktion in die Nähe des Leiters (1) gebracht wird,
- mittels einer mit dem Messkörper (11) verbundenen Messeinrichtung ein Signal erzeugt wird, das ein Maß für eine magnetostriktive Größenänderung des Materials ist,
- aus dem Signal der Strom im Leiter (1) ermittelt wird.

## Claims

1. Arrangement (10, 20, 30, 40, 50) for measuring current at an electrical conductor (1) having
- a measurement body (11), which has a continuous opening for feeding through the electrical conductor (1) and a material with magnetostriction and is formed in the manner of a coil having a plurality of windings around the opening for feeding through the electrical conductor (1),
- a measurement device connected to the measurement body (11), which measurement device is designed to generate a signal, which is a measure for a magnetostrictive change in size of the material.

2. Arrangement (10, 20, 30, 40, 50) according to Claim 1, in which the measurement body (11) has a cavity (12).

3. Arrangement (10, 20, 30, 40, 50) according to Claim 2, in which the cavity (12) is filled with a liquid.

4. Arrangement (10, 20, 30, 40, 50) according to Claim 2 or 3, in which the measurement device comprises a pressure sensor (16) for measuring the pressure in the cavity (12).

5. Arrangement (10, 20, 30, 40, 50) according to Claim 2 or 3, in which the measurement device comprises a device (22) for generating sound and a microphone (21) for receiving the sound.

6. Arrangement (10, 20, 30, 40, 50) according to Claim 1, in which the measurement device comprises an optical waveguide (31), which is connected to the measurement body (11) in a force-fitting manner.

7. Arrangement (10, 20, 30, 40, 50) according to either of Claims 1 and 2, which comprises mirrors (41) or mirrored surfaces (51) .

8. Arrangement (10, 20, 30, 40, 50) according to one of the preceding claims, in which the measurement body (11) is pretensioned in a magnetic or mechanical manner.

9. Arrangement (10, 20, 30, 40, 50) according to one of the preceding claims, having a temperature sensor for determining the temperature of the measurement body (11).

10. Arrangement (10, 20, 30, 40, 50) according to one of the preceding claims, which comprises a second measurement body having a second measurement device, wherein the second measurement body has a low or no magnetostriction.

11. Arrangement (10, 20, 30, 40, 50) according to Claim 10, in which the measurement bodies (11) have the same coefficient of thermal expansion.

12. Method for measuring current at a current-carrying conductor (1), in which
- a measurement body (11) formed in the manner of a coil and having a plurality of windings around an opening for feeding through the conductor (1) and having a material with magnetostriction is brought close to the conductor (1),
- a signal is generated by means of a measurement device connected to the measurement body (11), which signal is a measure for a magnetostrictive change in size of the material,
- the current in the conductor (1) is identified from the signal.

## Revendications

1. Système (10, 20, 30, 40, 50) de mesure du courant dans un conducteur (1) électrique, comprenant
- un corps (11) de mesure, qui a une ouverture traversante pour le passage du conducteur (1) électrique, ainsi qu'un matériau à magnétostriction, et qui est constitué à la manière d'une bobine, ayant une pluralité de spires autour de l'ouverture de passage du conducteur (1) électrique,
- un dispositif de mesure, qui est relié au corps (11) de mesure et qui est conformé pour produire un signal, qui est une mesure de la variation de la magnétostriction du matériau.

2. Système (10, 20, 30, 40, 50) suivant la revendication 1, dans lequel le corps (11) de mesure a une cavité (12 ).

3. Système (10, 20, 30, 40, 50) suivant la revendication 2, dans lequel la cavité (12) est remplie d'un liquide.

4. Système (10, 20, 30, 40, 50) suivant la revendication 2 ou 3, dans lequel le dispositif de mesure comprend une sonde (16) de pression pour mesurer la pression dans la cavité (12).

5. Système (10, 20, 30, 40, 50) suivant l'une des revendications 2 ou 3, dans lequel le dispositif de mesure comprend un dispositif (22) de production du son, ainsi qu'un microphone (21) de réception du son.

6. Système (10, 20, 30, 40, 50) suivant la revendication 1, dans lequel le dispositif de mesure comprend une fibre (31) optique, qui est reliée à complémentarité de force au corps (11) de mesure.

7. Système (10, 20, 30, 40, 50) suivant l'une des revendications 1 ou 2, qui comprend des miroirs (41) ou des surfaces (51) métallisées.

8. Système (10, 20, 30, 40, 50) suivant l'une des revendications précédentes, dans lequel le corps (11) de mesure est précontraint magnétiquement ou mécaniquement.

9. Système (10, 20, 30, 40, 50) suivant l'une des revendications précédentes, comprenant une sonde de température pour déterminer la température du corps (11) de mesure.

10. Système (10, 20, 30, 40, 50) suivant l'une des revendications précédentes, qui comprend un deuxième corps de mesure ayant un deuxième dispositif de mesure, le deuxième corps de mesure ayant une magnétostriction plus petite ou n'ayant pas de magnétostriction.

11. Système (10, 20, 30, 40, 50) suivant la revendication (10), dans lequel les corps (11) de mesure ont un même coefficient de dilatation thermique.

12. Procédé de mesure du courant dans un conducteur (11), dans lequel il passe du courant, dans lequel
- on met, à proximité du conducteur (1), un corps (11) de mesure, constitué à la manière d'une bobine et ayant une pluralité de spires autour d'une ouverture de passage du conducteur (1) et en un matériau à magnétostriction,
- au moyen d'un dispositif de mesure relié au corps (11) de mesure, on produit un signal, qui est une mesure d'une variation de magnétostriction du matériau,
- on détermine le courant dans le conducteur (1) à partir du signal.
